# EUROPEAN PATENT APPLICATION

(11) **EP 4 576 180 A1**
(43) Date of publication of application: **25.06.2025**
(21) Application number: 23219397.9
(22) Date of filing: 21.12.2023
(51) Int. Cl.: H01L 21/67, H01L 23/00, H05K 13/04

(54) **INERT-ATMOSPHERE PROCESSING SYSTEM FOR A BONDING STATION**

(71) Applicant: Infotech, AG, 4500 Solothurn (CH)
(72) Inventor: FISCHER, Ernest, 3267 Seedorf (CH); BÜRGI, Urs, 3270 Aarberg (CH); WALKER, Hanspeter, 2544 Bettlach (CH); FERRANDO, Frédéric, 1428 Mutrux (CH)
(74) Representative: Keller Schneider Patent- und Markenanwälte AG

(57) **Abstract**

The invention relates to a processing system for handling a workpiece carrier equipped with a workpiece, wherein the processing system is configured to interact with a bonding system for attaching a bonding partner to the workpiece, wherein the processing system comprises a workpiece carrier support for holding and transporting the workpiece carrier through the processing system. The processing system comprises a main process section with a shutter system, with the shutter system being able to at least partially, and in particular fully, cover a bonding partner access area to the main process section, wherein through the bonding partner access area the bonding partner is insertable by the bonding system into the main process section, wherein the bonding partner access area comprises a first access area direction and a second access area direction orthogonal to the first access area direction, with a partial cover provided by the shutter system providing an access opening in the bonding partner access area, wherein the shutter system is able to adapt an access opening position and/or an access opening extent of the access opening at least along one of (i) the first access area direction and (ii) the second access area direction. The main process section further comprises an inert gas supply system for supplying an inert gas, in particular nitrogen, into a space of the main process section between the bonding partner access area and a main process section part of the workpiece carrier support. The invention also relates to a method for handling a workpiece carrier equipped with a workpiece in the processing system and to a computer program product.

## Description

### Technical Field

The invention relates to 1) a processing system for handling a workpiece carrier equipped with a workpiece, to 2) a bonding station comprising the processing system and a bonding system, to 3) a method for handling a workpiece carrier equipped with a workpiece in the processing system, to 4) a method for attaching a bonding partner to a workpiece in the bonding station, and to 5) a computer program product.

### State of the art

To reduce unwanted oxidation, in bonding stations, in particular pre-sintering stations or sintering stations, often an inert environment is created. Such known bonding stations may comprise a closable chamber in which a bonding partner is attached to a workpiece by applying suitable temperatures and pressures; the bonding partner is typically attached, in particular sintered or pre-sintered, only after the chamber has been closed.

In bonding stations as known in the prior art, an inert environment may therefore be provided at the cost of a reduced throughput as such closable chambers cannot readily and quickly be accessed to insert new workpieces and/or bonding partners to be bonded to one another.

### Summary of the invention

It is the object of the invention to provide a processing system for handling a workpiece carrier equipped with a workpiece and a method for handling a workpiece carrier equipped with a workpiece that mitigate at least some of the disadvantages of processing systems and methods for handling workpiece carriers as known in the prior art.

The solution of the invention is specified by the features of claims 1, 13 and 15.

According to a first aspect of the invention, the invention relates to a processing system for handling a workpiece carrier equipped with a workpiece, wherein the processing system is configured to interact with a bonding system for attaching a bonding partner to the workpiece, wherein the processing system comprises a workpiece carrier support for holding and transporting the workpiece carrier through the processing system. The processing system comprises a main process section with a shutter system, with the shutter system being able to at least partially, and in particular fully, cover the bonding partner access area to the main process section, wherein through the bonding partner access area the bonding partner is insertable by the bonding system into the main process section, wherein the bonding partner access area comprises a first access area direction and a second access area direction orthogonal to the first access area direction, with a partial cover provided by the shutter system providing an access opening in the bonding partner access area, wherein the shutter system is able to adapt an access opening position and/or an access opening extent of the access opening at least along one of (i) the first access area direction and (ii) the second access area direction. The main process section further comprises an inert gas supply system for supplying an inert gas, in particular nitrogen, into a space of the main process section between the bonding partner access area and a main process section part of the workpiece carrier support.

The processing system according to the first aspect of the invention is configured to interact with a bonding system for attaching a bonding partner to a workpiece. The processing system is configured to provide an inert atmosphere in which the attachment may take place.

The workpiece may be embodied as a direct bonded copper (DBC) substrate, or as active metal brazed (AMB) substrate, or as insulated metal substrate (IMS). The workpiece may also be embodied as a baseplate or as a cooling plate/heatsinl</water jacket or as a module, for example a power electronics module or a multi-chip module. The workpiece may also be embodied as a ceramic substrate. The bonding partner may be embodied as an integrated circuit or semiconductor. The bonding partner may also be embodied as a copper pad or as an active or passive electronic component. The bonding partner may also be embodied as a module, for example a power electronics module or a multi-chip module. The bonding partner may also be embodied as a DBC substrate, AMB substrate or IMS, or the bonding partner may be embodied as a pin housing.

The bonding system that the processing system is configured to interact with may typically comprise a bonding head that may comprise holding means, for example vacuum suction means, to hold the bonding partner; the bonding system may also comprise heating means.

The processing system and the bonding system may together be part of a bonding station in which the bonding partner is attached to the workpiece, e.g. using pre-sintering, sintering, eutectic bonding or diffusion soldering. A bonding station in which the bonding partner is attached to the workpiece using pre-sintering may be termed pre-sintering station. An analogous naming of the bonding station may also be used if the bonding station uses sintering, eutectic bonding or diffusion soldering, i.e. sintering station, eutectic-bonding station and diffusion-soldering station. A bonding station may be both a pre-sintering station and a sintering station, i.e. such a bonding station may be able to provide pressures between the bonding partner and the workpiece and temperatures suitable for pre-sintering or sintering. In case the bonding station is used for pre-sintering, the processing system and the bonding system may jointly be configured in such a way that during pre-sintering, the bonding partner may be pressed with a pressure of up to 6 MPa, in particular up to 3 MPa, against the workpiece and a temperature of less than 200° Celsius, in particular less than 150° Celsius, may be provided. The bonding station comprising the processing system may also be used for sintering a bonding partner to a workpiece, in particular in case a size of a sintering area where the bonding partner and the workpiece are connected is sufficiently small. The bonding station for sintering may be embodied in such a way that the bonding partner may be pressed with a pressure of up to 30 MPa against the workpiece and a temperature of up to 300° Celsius may be provided.

In case the bonding station is used for pre-sintering or sintering, the workpiece and/or the bonding partner may be provided with a sintering material, in particular embodied as a sintering paste, which sintering material between the workpiece and the bonding partner may (i) partially harden during pre-sintering, thereby pre-fixing the bonding partner to the workpiece before a subsequent sintering process may be carried out, potentially in a different station, or (ii) fully harden during sintering, thereby fully fixing the bonding partner to the workpiece.

The processing system comprises a main process section, wherein an attaching of the bonding partner to the workpiece may take place in the main process section. Through a bonding partner access area to the main process section, the bonding partner is insertable into the main process section by the bonding system.

In case the processing system is placed in an envisaged manner on a flat ground, the bonding partner access area may be parallel to the flat ground and a normal to the bonding partner access area may be parallel to a direction in which gravity applies. The processing system may be such that when placed in the envisaged manner, the bonding partner may be insertable "from above" into the main process section by the bonding system.

The bonding partner access area may be a plane area defined with respect to the main process section, in particular with respect to the shutter system of the main process section. The bonding partner access area may correspond to a plane area through a spatially maximized access opening, wherein the spatially maximized access opening corresponds to an access opening with the largest possible spatial extent that may be provided by the shutter system. The bonding partner access area may also correspond to a plane area composed of a union of all possible access openings that may be provided by the shutter system, with the term union in particular being defined as usual in set theory. In case the shutter system comprises a coplanar first shutter plate and second shutter plate that can be moved along a linear guide, for example, the bonding partner access area may be aligned with the coplanar first and second shutter plates and an outer circumference of the bonding partner access area may correspond to an outer circumference of the largest possible access opening which may be obtained by such a shutter system. In case the main process section comprises a mask plate, the bonding partner access area may be parallel to the mask plate.

Oxygen is present in air and may oxidize surfaces of the workpiece and/or of the bonding partner at temperatures needed for attaching the bonding partner to the workpiece, for example using pre-sintering/sintering, and thereby alter their behaviour. In case of a direct bonded copper substrate, a copper surface may start oxidizing at 80° Celsius, for example: the inert gas supply system of the processing system is configured in such a way that an inert gas, in particular nitrogen, is supplied to reduce such oxidation, the supplied inert gas washing out oxygen in a space of the main process section between the bonding partner access area and a main process section part of the workpiece carrier support.

The inert gas supply system may be configured to provide the inert gas continuously to the space of the main process section between the bonding partner access area and the main process section part of the workpiece carrier support. This way, an inert atmosphere may already be present in the main process section before the workpiece carrier is moved by the workpiece carrier support into the main process section. The inert gas supply system may alternatively be configured to provide the inert gas intermittently to the space of the main process section between the bonding partner access area and the main process section part of the workpiece carrier support. In a direction normal to the bonding partner access area, the space of the main process section between the bonding partner access area and the main process section part of the workpiece carrier support may preferentially have an extent of less than 5 cm: the inert gas supply system may advantageously thus quickly provide an inert atmosphere as the volume to be filled with an inert gas may be small.

The inert gas supply system may further monitor a proportion of oxygen in the space of the main process section between the bonding partner access area and the main process section part of the workpiece carrier support: based on the monitored proportion of oxygen, the inert gas supply system may be configured to vary a flow rate of the supplied inert gas and/or a time duration of supply in case the inert gas supply system is configured to supply the inert gas intermittently. In case the monitored proportion of oxygen is too high and unwanted oxidation may take place, the flow rate of the supplied inert gas may be increased, for example.

The inert gas supply system may be controlled by a control algorithm, wherein the control algorithm may be configured to ensure that the proportion of oxygen in the space of the main process section between the bonding partner access area and the main process section part of the workpiece carrier support is below a pre-set oxygen threshold. The control algorithm of the inert gas supply system may be operated independently of the shutter system. The control algorithm may implement, for example, a proportional-integral-derivative controller or other suitable controllers as known from control literature. The control algorithm of the inert gas supply system may, however, also take movement of the shutter system into account to maintain the proportion of oxygen below the pre-set oxygen threshold: the control algorithm may, for example, vary the flow rate of the supplied inert gas not only based on the measured proportion of oxygen, but also based on a spatial extent and/or position of the access opening; when the spatial extent of the access opening is large, for example, the flow rate of the supplied inert gas may be set higher by the inert gas supply system than in case the spatial extent of the access opening is small.

The bonding partner access area comprises a first access area direction and a second access area direction that is orthogonal to the first access area direction. The first access area direction and the second access area direction may be considered as coordinate axes of a two-dimensional coordinate system of the bonding partner access area. The shutter system is embodied in such a way that in at least one of (i) the first access area direction and (ii) the second access area direction, the shutter system is able to adapt an access opening position and/or an access opening extent of the access opening, in particular both the access opening position and the access opening extent. The access opening position may be defined as a centroid of the access opening. In case the access opening extent may be controlled, the shutter system may be able to control the access opening extent in the first access area direction and/or in the second access area direction.

The shutter system may provide an access opening which may be dynamically adapted to the requirements of the bonding system: in case the bonding system is scheduled to attach the bonding partner to the workpiece, the access opening may be adapted in such a way that (i) the bonding system may attach the bonding partner to the workpiece, while at the same time (ii) the bonding partner access area is kept as covered as possible by the shutter system. This way, a disturbance of the inert atmosphere in the space of the main process section between the bonding partner access area and a main process section part of the workpiece carrier support may be minimized, and at the same time a high throughput may be possible as the bonding system can easily and quickly reach the workpiece to attach the bonding partner to the workpiece.

The workpiece carrier may comprise a plurality of cavities; each cavity of the plurality of cavities may be equipped with a respective workpiece. The processing system may also be configured to handle a workpiece carrier equipped with a plurality of workpieces. The bonding system may be configured in such a way that it sequentially attaches respective bonding partners to the respective plurality of workpieces. The shutter system may then be configured in such a way that the dynamically adapted access opening tracks movement of the bonding system so that, at a given time when the bonding system may be scheduled to attach a bonding partner to a specific workpiece of the plurality of workpieces, the access opening may be specifically adapted to this scheduled attachment step.

The shutter system may be configured to cover the bonding partner access area fully when the bonding system is carrying out tasks other than attaching the bonding partner to the workpiece. When the bonding system is picking up the bonding partner from an external bonding partner source, for example, the shutter system may be configured to cover the bonding partner access area fully: this way, an inert atmosphere may be better maintained in the main process section.

In case the workpiece carrier support comprises transport casters, for example, the space of the main process section between the bonding partner access area and the main process section part of the workpiece carrier support may be defined as the space between the bonding part access area and a, in particular fictional, plane which touches the transport casters at contact points at which the transport casters may contact the workpiece carrier. More generally, the space of the main process section between the bonding partner access area and the main process section part of the workpiece carrier support may be defined as the space between the bonding partner access area and a, in particular fictional, plane, which plane is in particular parallel to the bonding partner access area, and which plane touches the contact points of the main process section part of the workpiece carrier at which the workpiece carrier may contact the workpiece carrier support.

The space between the bonding partner access area and the main process section part of the workpiece carrier support is such that, when the workpiece carrier is in the main process section, at least a part of the workpiece equipped on the workpiece carrier is inside said space. More specifically, at least those parts of the equipped workpiece may be inside said space to which the bonding system may attached a bonding partner. The workpiece carrier, workpiece carrier support and workpiece may also be designed in such a way that, when the workpiece carrier is in the main process section, the entire workpiece is in the space between the bonding partner access area and the main process section part of the workpiece carrier support.

In an embodiment of the processing system according to the first aspect of the invention, the main process section further comprises a heating element structure, wherein the heating element structure comprises a heating element, in particular comprising a heating film, and wherein, in case the workpiece carrier is arranged in the main process section, the equipped workpiece is arranged between the heating element and the bonding partner access area.

The heating element structure may heat the workpiece up to a temperature needed for attaching the bonding partner to the workpiece, for example to a temperature at which pre-sintering/sintering may be carried out. The position of the heating element in the heating element structure may be tailored to the position of the workpiece on the workpiece carrier: advantageously, thus a more precise control of heating of the workpiece is possible as the heating element may directly contact the workpiece. In case the processing system is configured for a workpiece carrier with a plurality of workpieces, the heating element structure may comprise a plurality of heating elements, wherein each heating element of the plurality of heating elements may correspond to a respective workpiece of the plurality of workpieces. The positions of the plurality of heating elements of the heating element structure may be tailored to the positions of the plurality of workpieces on the workpiece carrier.

In a further embodiment of the processing system according to the first aspect of the invention, the main process section further comprises a mask plate, wherein the mask plate comprises a cut-out, wherein the mask plate is arranged between the heating element structure and the bonding partner access area, and wherein, in case the workpiece carrier is arranged in the main process section, the mask plate is arranged between the workpiece carrier and the bonding partner access area.

The position and shape of the cut-out of the mask plate may correspond to the position and shape of the workpiece on the workpiece carrier. The bonding system may be configured to attach the bonding partner to the workpiece through the cut-out. In case the processing system is configured for a workpiece carrier with a plurality of workpieces, the mask plate may comprise a plurality of cut-outs, wherein each cut-out of the plurality of cut-outs may correspond to a respective workpiece of the plurality of workpieces.

In a further embodiment of the processing system according to the first aspect of the invention, the main process section further comprises a lifting axis and a force-measuring unit, wherein the force-measuring unit is arranged between the lifting axis and the heating element structure, and wherein the mask plate comprises at least one flat spring, in particular embodied as leaf spring, around the cut-out which at least one flat spring partially extends into the cut-out.

The processing system may be configured to push the workpiece from the cavity of the workpiece carrier in which the workpiece may be arranged into the cut-out and against the at least one flat spring by actuating the heating element structure, specifically the heating element, through the lifting axis: after pushing the workpiece into the cut-out, the workpiece may be positioned between the heating element and the at least one flat spring partially extending into the cut-out. In case the processing system is configured for a workpiece carrier with a plurality of cavities in which a respective plurality of workpieces may be equipped, the equipped workpieces may be pushed out of their respective cavities by the heating element structure, specifically the respective heating elements, which in turn is actuated by the lifting axis, into their respective cut-outs in the mask plate, and each of the plurality of cut-outs may respectively comprise at least one flat spring.

The mask plate may be arranged in such a way in the main process section that forces acting only on the mask plate do not displace the mask plate with respect to remaining parts of the main process section. The lifting axis may therefore push the workpieces against the flat springs of the mask plate that each may be rigidly attached to the mask plate at one end respectively, and the mask plate may constrain possible movement of the workpieces. The flat springs partially extending into the cut-outs may advantageously level the workpieces and thereby improve an attachment of bonding partners by the bonding system.

The force-measuring unit may be used to measure a force applied by the bonding system, in particular the bonding head of the bonding system, onto the workpiece. This way, the pressure acting on the workpiece and the bonding partner during the attachment, in particular using pre-sintering/sintering, may be precisely controlled. The processing system may be configured to provide measurements provided by the force-measuring unit to the bonding system.

In a further embodiment of the processing system according to the first aspect of the invention, a supply duct of the inert gas supply system is integrated into the mask plate and ends at the cut-out, wherein the inert gas supply system is configured to supply the inert gas through the supply duct, with the supplied inert gas leaving the supply duct at the cut-out, and an analysis duct of the inert gas supply system is integrated into the mask plate and ends at the cut-out, wherein the inert gas supply system is configured in such a way that a lower pressure is applied in the analysis duct compared to a pressure in the cut-out, with the lower pressure sucking in a main process section gas into the analysis duct at the cut-out, and the inert gas supply system further comprises an oxygen sensor which is configured to determine a proportion of oxygen in the main process section gas sucked in through the analysis duct, and the inert gas supply system is configured to control a flow rate of the supplied inert gas based on the determined proportion of oxygen in the main process section gas.

In case the processing system is configured for a workpiece carrier with a plurality of cavities in which a respective plurality of workpieces may be equipped, the mask plate may comprise a plurality of cut-outs. In this case, each of the cut-outs may comprise its own supply duct, analysis duct and oxygen sensor, and the inert gas supply system may be configured to control the supply of the inert gas separately for each cut-out. Alternatively, the inert gas supply system may also be configured to jointly control the supply of the inert gas for all cut-outs by, for example, controlling the flow rate of the inert gas through a common supply duct which may be connected to the respective supply ducts leading to the cut-outs: the flow rate of the inert gas through such a common supply duct may, for example, be controlled based on a highest proportion of oxygen detected by any of the plurality of oxygen sensors.

An inert gas supply system for which the supply duct ends at the cut-out may advantageously enable an improved control over an inert atmosphere close to the workpiece, in particular in the cut-outs. As the cut-outs are supplied with the inert gas, oxygen advantageously cannot easily enter into parts of the main process section below the mask plate so that the workpiece carrier may also be in an inert atmosphere before the workpieces are pushed up into the cut-outs by the action of the lifting axis.

In a further embodiment of the processing system according to the first aspect of the invention, the inert gas supply system is configured to supply the inert gas continuously through the supply duct, and the inert gas supply system is configured to maintain an inert atmosphere between the mask plate and the shutter system.

In a further embodiment of the processing system according to the first aspect of the invention, the processing system further comprises a pre-heating section.

The processing system may be configured to heat the workpiece on the workpiece carrier to a first temperature before transporting the workpiece carrier with the workpiece to the main process section. The processing system may be configured to provide an inert atmosphere in the pre-heating section as well.

In a further embodiment of the processing system according to the first aspect of the invention, the processing system further comprises a cooling section.

In the cooling section, workpieces with attached bonding partner may be cooled down before being transported to a further processing site. The processing system may be configured to provide an inert atmosphere in the cooling section as well.

In a further embodiment of the processing system according to the first aspect of the invention, the workpiece carrier support of the processing system is configured to transport the workpiece carrier in a main transport direction from the pre-heating section into the main process section and/or from the main process section into the cooling section, and wherein a first retractable separation wall is arranged between the pre-heating section and the main process section and/or wherein a second retractable separation wall is arranged between the main process section and the cooling section.

The first retractable separation wall may advantageously enable an improved control over an inert atmosphere close to the workpiece. The processing system may be configured to retract the first retractable separation wall only while transporting the workpiece carrier from the pre-heating section into the main process section. When the workpiece carrier is in the main process section, the first retractable separation wall may at least partly seal the main process section.

The second retractable separation wall may advantageously enable an improved control over an inert atmosphere close to the workpiece. The processing system may be configured to retract the second retractable separation wall only while transporting the workpiece carrier from the main process section into the cooling section. When the workpiece carrier is in the main process section, the second retractable separation wall may at least partly seal the main process section.

In a further embodiment of the processing system according to the first aspect of the invention, the shutter system comprises a first shutter plate, a first linear motor, a second shutter plate, a second linear motor and a linear guide, with the first linear motor and the second linear motor being movable along the linear guide, and with the first linear motor being connected to the first shutter plate and with the second linear motor being connected to the second shutter plate.

The first shutter plate and the second shutter plate may be coplanar. The linear guide may be arranged in such a way that the first shutter plate and the second shutter plate may be moved in a parallel and an antiparallel manner to the main transport direction. The first shutter plate may be moved independently from the second shutter plate.

In a further embodiment of the processing system according to the first aspect of the invention, the shutter system further comprises a third shutter plate, a third linear motor, a fourth shutter plate, a fourth linear motor and a second linear guide, with the third linear motor and the fourth linear motor being movable along the second linear guide, with the third linear motor being connected to the third shutter plate and with the fourth linear motor being connected to the fourth shutter place, wherein the second linear guide is arranged in a substantially orthogonal manner with respect to the linear guide, wherein the first shutter plate and the second shutter plate are coplanar, and wherein the third shutter plate and the fourth shutter plate are coplanar and lie in a different plane compared to the first shutter plate and the second shutter plate.

The third shutter plate and the fourth shutter plate may be arranged in such a way that they may be moved in a direction orthogonal to both (i) the main transport direction and (ii) a normal to the bonding partner access area. The plane in which the first shutter plate and the second shutter plate lie may be parallel to the plane in which the third shutter plate and the fourth shutter plate lie. Advantageously, the access opening position and the access opening extent of the access opening may thereby be controlled in an improved manner by the processing system.

In a further embodiment of the processing system according to the first aspect of the invention, the shutter system comprises a circular shutter plate with a hole, wherein a hole centre of the hole is positioned away from a shutter plate centre of the circular shutter plate, with the circular shutter plate in particular being arranged above the mask plate and being parallel to the mask plate, and wherein the processing system comprises linear translation means enabling bidirectional translatory movement of the circular shutter plate along a main translation direction, which main translation direction in particular coincides with the main transport direction, and wherein the processing system comprises rotation means for rotating the circular shutter plate with respect to a rotation axis passing through the shutter plate centre.

The hole in the circular shutter plate may be placed away from a shutter plate centre, in particular a centroid, of the circular shutter plate. A rotation of the circular shutter plate with respect to a rotation axis passing through the shutter plate centre may thereby also change the position of the hole in the circular shutter plate with respect to the remaining main process section, in particular with respect to the mask plate and the workpiece carrier. The circular shutter plate may have a diameter that is larger than a maximum width of the workpiece carrier in a direction orthogonal to both (i) the main translation direction, in particular the main transport direction, and (ii) the rotation axis. The circular shutter plate may in particular be sized in such a way that to reach the workpiece carrier, the bonding system needs to insert the bonding partner through the hole in the circular shutter plate.

The hole in the circular shutter plate may be adapted to the bonding system. The hole may in particular be as small as possible while still allowing the bonding system to insert the bonding partner through the hole into the main process section and to place it on the workpiece. Depending on a distance of the hole centre from the shutter place centre, which hole centre may correspond to the centroid of the hole, the hole may be positioned at different positions with respect to the mask plate and the workpiece carrier by the linear translation and/or the rotation around the rotation axis. To enable the bonding system to place the bonding partner on the workpiece, the hole of the circular shutter plate may be positioned above the workpiece and the cut-out of the mask plate.

In a further embodiment of the processing system according to the first aspect of the invention, the workpiece carrier support comprises transport casters.

The workpiece carrier may be positioned on transport casters. The processing system may further comprise two lateral guides on each side to guide the workpiece carrier during transport.

A processing system according to the first aspect of the invention may be comprised by a bonding station, which bonding station may also comprise a bonding system. The bonding station may be embodied as a pre-sintering station and/or as a sintering station. The bonding station may also be embodied as a eutectic-bonding station or as a diffusion-soldering station.

According to a second aspect of the invention, the invention relates to a method for handling a workpiece carrier equipped with a workpiece in a processing system according to the first aspect of the invention, wherein the processing system is configured to interact with a bonding system for attaching a bonding partner to the workpiece, wherein a minimum spatial extent of the access opening required by the bonding system for being able to insert the bonding partner into the main process section and to attach the bonding partner to the workpiece comprises a minimum first spatial extent in the first access area direction and a minimum second spatial extent in the second access area direction. The method according to the second aspect of the invention comprises the following steps: 1) moving the workpiece carrier into the main process section; 2) providing or receiving position information on a planned attachment position on the workpiece carrier, wherein the bonding system is scheduled to attach the bonding partner to the workpiece on the workpiece carrier at the planned attachment position; and 3) providing an adapted access opening based on the provided or received position information, wherein an adapted spatial extent of the adapted access opening is, in at least one of (i) the first access area direction and (ii) the second access area direction, substantially equal to the minimum first spatial extent or the minimum second spatial extent, respectively.

To insert the bonding partner into the main process section, the bonding system requires a minimum spatial extent of the access opening. In case the processing system is adapted for handling a worl<piece carrier on which a plurality of workpieces are arranged to which bonding partners are to be attached by the bonding system, the bonding system may be configured to attach the respective bonding partners in a sequential manner, i.e., one after another.

The processing system may therefore receive information from the bonding system to which workpiece on the workpiece carrier the bonding system is scheduled to next attach a bonding partner. Alternatively, in case the sequence in which bonding partners are to be attached to the workpieces on the workpiece carrier is pre-set, this sequence may be preconfigured and known to the processing system, i.e. the processing system may provide the respective next planned attachment position itself.

The planned attachment position corresponds therefore to a workpiece on the workpiece carrier to which the bonding system is configured to next attach a bonding partner. In case the positions of the workpieces on the workpiece carrier are known, the planned attachment position may be embodied as a logical information for identifying the respective next workpiece on the workpiece carrier to which a bonding partner is to be attached; alternatively, the planned attachment position may be described as actual coordinate data in a suitable coordinate system.

The shutter system of the processing system next adapts the access opening so that the bonding system may insert the bonding partner into the main process section and attach it to the workpiece corresponding to the planned attachment position. Within the possible constraints of the shutter system, this adapted access opening is set as small as possible while still enabling such insertion and attachment of the bonding partner by the bonding system. Between attachment step 'i' and attachment step 'i+1', for example, 'i' being an integer-valued variable, the shutter system may fully cover the bonding partner access area for some time.

The method according to the second aspect of the invention may be used in a method for attaching a bonding partner to a workpiece in a bonding station, in particular embodied as a pre-sintering station and/or sintering station, or as an eutectic-bonding station, or as a diffusion-soldering station, wherein the method for attaching a bonding partner to a workpiece comprises the following steps: 1) carrying out the method according to the second aspect of the invention; 2) inserting the bonding partner through the adapted access opening into the main process section and placing the bonding partner on the workpiece; and 3) attaching the bonding partner to the workpiece.

In case the processing system comprises the mask plate, the heating element structure, the lifting axis and the force-measuring unit, before the placing of the bonding partner on the workpiece, the processing system may carry out the following steps: (a) pushing the worl<piece from a cavity in the worl<piece carrier in which the workpiece is placed using the heating element of the heating element structure, wherein the pushing is actuated by the lifting axis, wherein the workpiece is pushed into the cut-out of the mask plate, the workpiece being held between the heating element and the at least one flat spring of the mask plate; and (b) heating the workpiece with the heating element.

The step of attaching the bonding partner to the workpiece in the method according to the second aspect of the invention may be carried out using pre-sintering, using sintering, using eutectic bonding, or using diffusion soldering.

According to a third aspect of the invention, the invention relates to a computer program product comprising program code which, when executed on a computing unit of a processing system according to the first aspect of the invention, causes the processing system to carry out a method according to the second aspect of the invention.

Other advantageous embodiments and combinations of features come out from the detailed description below and the entirety of the claims.

### Brief description of the drawings

The drawings used to explain the embodiments show:
- Fig. 1: shows a perspective view of a processing system;
- Fig. 2: shows a view of the processing system of Fig. 1 from above and a cross-sectional view through the processing system of Fig. 1; and
- Fig. 3: shows a perspective view of the processing system of Fig. 1 cut open.

In the figures, the same components are given the same reference symbols.

### Detailed description of the drawings

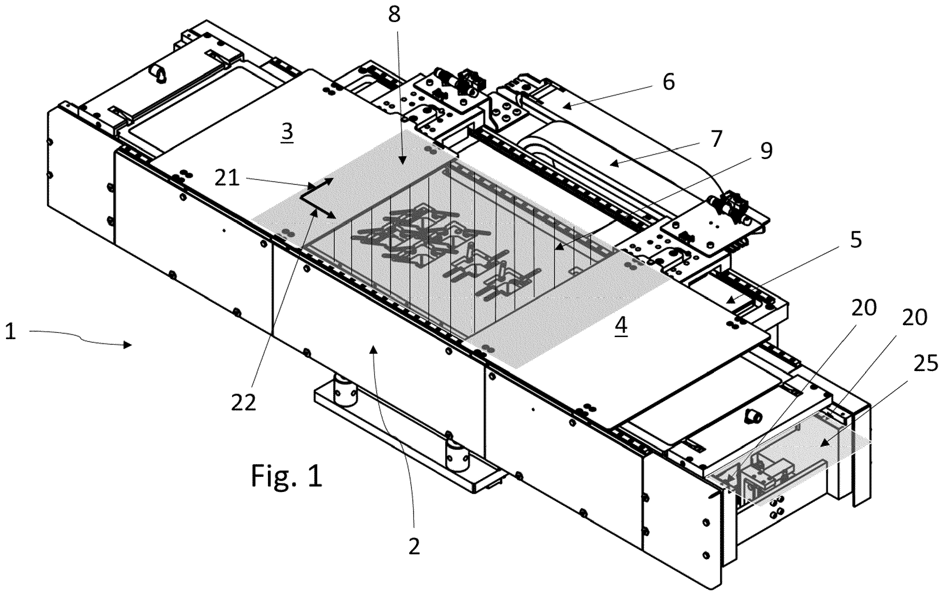

**Fig. 1** shows a perspective view of a processing system 1. In Fig. 1, a shutter system with a first shutter plate 3, a second shutter plate 4, a linear guide 5, a first linear motor 6 and a second linear motor 7 is shown. The first shutter plate 3 and the second shutter plate 4 may be moved independently of each other along the linear guide 5.

A bonding partner access area 8 is coplanar with the first shutter plate 3 and the second shutter plate 4 and corresponds to a largest possible access opening which can be provided by maximally separating the first shutter plate 3 from the second shutter plate 4 along the linear guide 5. The bonding partner access area 8 comprises a first access area direction 21 and a second access area direction 22 that is orthogonal to the first access area direction 21.

In the situation depicted in Fig. 1, the first shutter plate 3 and the second shutter plate 4 are not maximally separated: the bonding partner access area 8 is therefore partly covered by the first shutter plate 3 and the second shutter plate 4, and between the first shutter plate 3 and the second shutter plate 4 the access opening 9 is provided.

With the shutter system of Fig. 1, an access opening extent of the access opening 9 may be controlled in the second access area direction 22; an access opening position of the access opening 9, e.g. defined as a centroid of the access opening 9, may also be controlled in the second access area direction 22. By suitably positioning the first shutter plate 3 and the second shutter plate 4, an access opening with a desired access opening position and access opening extent may be provided.

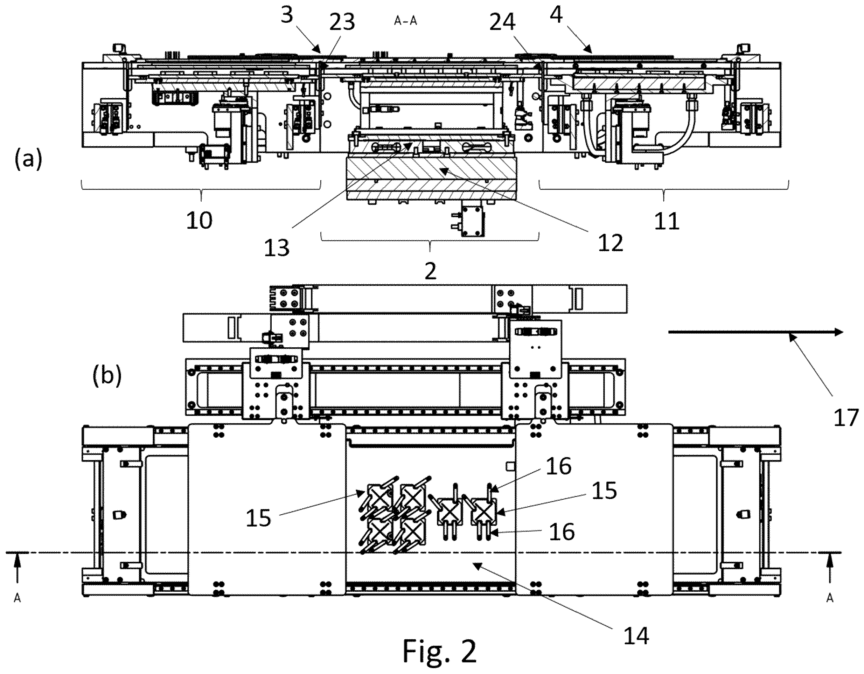

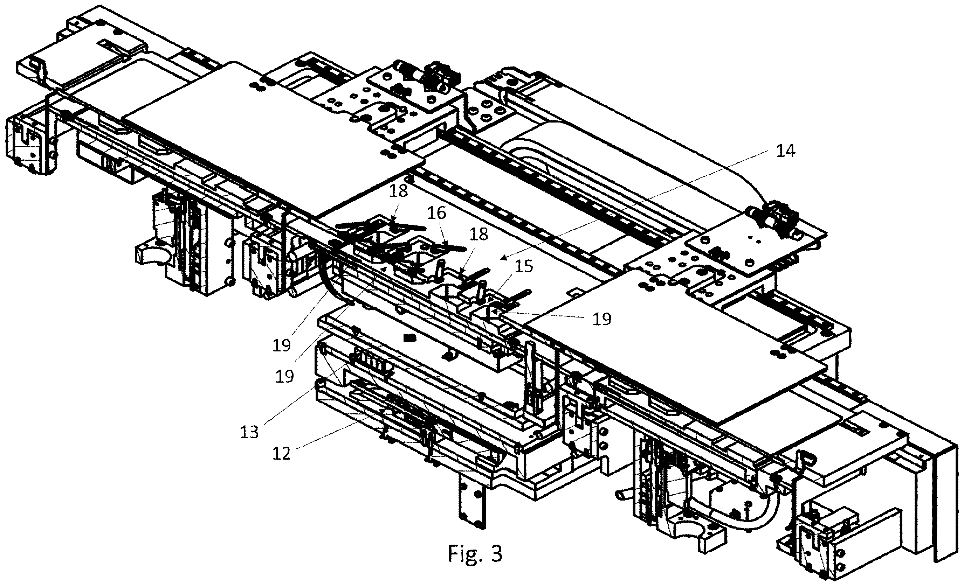

A bonding system (not shown) may insert a bonding partner through the access opening 9 into a main process section 2. The main process section 2 is explained in detail in the description of Fig. 2 and Fig. 3. The processing system 1 comprises a workpiece carrier support 20, in particular embodied as transport casters and lateral guides, for transporting a workpiece carrier equipped with workpieces through the processing system 1.

A fictional plane 25 is shown in Fig. 1 which touches the transport casters of the workpiece carrier support 20 at contact points at which the transport casters may contact the workpiece carrier. The fictional plane 25 of Fig. 1 may be extended through the whole processing system 1. A space of a main process section between the bonding partner access area 8 and a main process section part of the workpiece carrier support 20 may be defined as the space between the fictional plane 25 in the main process section part and the bonding partner access area 8.

**Fig. 2a** shows a cross-sectional view through the processing system 1 of Fig. 1, while **Fig. 2b** shows a view from above of the processing system 1 of Fig. 1. For the cross-sectional view of Fig. 2a, the processing system 1 of Fig. 1 is cut open at the line A-A shown in Fig. 2b, with the viewing direction indicated by the arrows adjacent to A-A.

The processing system 1 comprises a main process section 2, a pre-heating section 10 and a cooling section 11. Workpiece carriers equipped with workpieces are transported in a main transport direction 17 by the workpiece carrier support through the processing system 1. The workpieces on the workpiece carriers are pre-heated to a first temperature in the pre-heating section 10 in an inert atmosphere that may be less inert, i.e. contain more oxygen, than an inert atmosphere in the main process section 2. After retracting a first retractable separation wall 23 between the pre-heating section 10 and the main process section 2, the workpiece carrier may be transported from the pre-heating section 10 to the main process section 2. A second retractable separation wall 24 separates the main process section 2 from the cooling section 11, in which cooling section 11 the workpiece carrier equipped with workpieces to which bonding partners have been attached may be cooled down. In the cooling section 11, an inert atmosphere may be present as well, which inert atmosphere in the cooling section 11 may, however, comprise more oxygen than the inert atmosphere in the main process section 2. The cooling section may comprise a water-cooling system.

The pre-heating section 10 and the cooling section 11 may each comprise a further retractable separation wall that is respectively retracted only when the workpiece carrier enters the pre-heating section 10 respectively leaves the cooling section 11.

The main process section 2 comprises a lifting axis 12 and a force-measuring unit 13 arranged above the lifting axis 12. The main process section 2 further comprises a mask plate 14 in which cut-outs 15 are arranged. In the example of Figs. 1 to 3, the mask plate 14 comprises six cut-outs 15. The number of cut-outs 15 as well as their shape and position in the mask plate 14 corresponds to the number, shape and position of workpiece cavities on the workpiece carrier in which workpieces may be arranged.

When the workpiece carrier is arranged in the main process section 2, the lifting axis may push up a heating element structure (shown in Fig. 3) that comprises a same number of heating elements as the number of cavities present in the workpiece carrier in which workpieces may be arranged. The positions of the heating elements correspond to the positions of the cavities in which workpieces may be arranged. The pushed up heating elements in turn lift the workpieces and push them against flat springs 16 on the mask plate 14, in particular leaf springs, that partially extend into the cut-outs 15 and that may level the workpieces, while the heating elements on which the pushed-out workpieces rest may heat the workpieces from below. The number and positions of the flat springs 16 may be specifically tailored to the layout of workpieces and the bonding partners to be attached. The force-measuring unit 13 may be used to determine a force exerted by a bonding system on the workpieces.

**Fig. 3** shows a perspective view of the processing system 1 of Fig. 1 cut open. In Fig. 3, supply ducts 18 of the inert gas supply system are visible, which supply ducts 18 end at the cut-outs 15. Each cut-out 15 is therefore directly supplied with inert gas by the inert gas supply system.

Below the mask plate 14 with the cut-outs 15 and the flat springs 16, the heating element structure 19 is visible. The heating element structure comprises heating elements which protrude towards the mask plate 14 and which are arranged below the corresponding cut-outs 15. When the workpiece carrier is arranged between the heating element structure 19 and the mask plate 14, the lifting axis may push the workpieces into the cut-outs 15 through the heating elements.

## Claims

1. Processing system (1) for handling a workpiece carrier equipped with a workpiece, wherein the processing system (1) is configured to interact with a bonding system for attaching a bonding partner to the workpiece, wherein the processing system comprises a workpiece carrier support (20) for holding and transporting the workpiece carrier through the processing system (1), and wherein the processing system (1) comprises a main process section (2) with
• a shutter system (3, 4, 5, 6, 7), with the shutter system (3, 4, 5, 6, 7) being able to at least partially, and in particular fully, cover a bonding partner access area (8) to the main process section (2), wherein through the bonding partner access area (8) the bonding partner is insertable by the bonding system into the main process section (2), wherein the bonding partner access area (8) comprises a first access area direction (21) and a second access area direction (22) orthogonal to the first access area direction (21), with a partial cover provided by the shutter system (3, 4, 5, 6, 7) providing an access opening (9) in the bonding partner access area (8), wherein the shutter system (3, 4, 5, 6, 7) is able to adapt an access opening position and/or an access opening extent of the access opening (9) at least along one of (i) the first access area direction (21) and (ii) the second access area direction (22), and
• an inert gas supply system (18) for supplying an inert gas, in particular nitrogen, into a space of the main process section (2) between the bonding partner access area (8) and a main process section part of the workpiece carrier support (20).

2. Processing system (1) according to claim 1, wherein the main process section (2) further comprises a heating element structure (19), wherein the heating element structure (19) comprises a heating element, in particular comprising a heating film, and wherein, in case the workpiece carrier is arranged in the main process section (2), the equipped workpiece is arranged between the heating element and the bonding partner access area (8).

3. Processing system (1) according to claim 2, wherein the main process section (2) further comprises a mask plate (14), wherein the mask plate (14) comprises a cut-out (15), wherein the mask plate (14) is arranged between the heating element structure (19) and the bonding partner access area (8), and wherein, in case the workpiece carrier is arranged in the main process section (2), the mask plate (14) is arranged between the workpiece carrier and the bonding partner access area (8).

4. Processing system (1) according to claim 3, wherein the main process section (2) further comprises a lifting axis (12) and a force-measuring unit (13), wherein the force-measuring unit (13) is arranged between the lifting axis (12) and the heating element structure (19), and wherein the mask plate (14) comprises at least one flat spring (16), in particular embodied as leaf spring, around the cut-out (15) which at least one flat spring (16) partially extends into the cut-out (15).

5. Processing system (1) according to claim 3 or 4, wherein a supply duct (18) of the inert gas supply system is integrated into the mask plate (14) and ends at the cut-out (15), wherein the inert gas supply system is configured to supply the inert gas through the supply duct (18), with the supplied inert gas leaving the supply duct (18) at the cut-out (15), wherein an analysis duct of the inert gas supply system is integrated into the mask plate (14) and ends at the cut-out (15), wherein the inert gas supply system is configured in such a way that a lower pressure is applied in the analysis duct compared to a pressure in the cut-out (15), with the lower pressure sucking in a main process section gas into the analysis duct at the cut-out (15), wherein the inert gas supply system further comprises an oxygen sensor which is configured to determine a proportion of oxygen in the main process section gas sucked in through the analysis duct, and wherein the inert gas supply system is configured to control a flow rate of the supplied inert gas based on the determined proportion of oxygen in the main process section gas.

6. Processing system (1) according to claim 5, wherein the inert gas supply system is configured to supply the inert gas through the supply duct (18) continuously, wherein the inert gas supply system is configured to maintain an inert atmosphere between the mask plate (14) and the shutter system (3, 4, 5, 6, 7).

7. Processing system (1) according to any one of the preceding claims, wherein the processing system (1) further comprises a pre-heating section (10), and/or wherein the processing system (1) further comprises a cooling section (11), and/or wherein the workpiece carrier support (20) comprises transport casters.

8. Processing system (1) according to claim 7, wherein the workpiece carrier support (20) of the processing system (1) is configured to transport the workpiece carrier in a main transport direction (17) from the pre-heating section (10) into the main process section (2) and/or from the main process section (2) into the cooling section (11), and wherein a first retractable separation wall (23) is arranged between the pre-heating section (10) and the main process section (2) and/or wherein a second retractable separation wall (24) is arranged between the main process section (2) and the cooling section (11).

9. Processing system (1) according to any one of the preceding claims, wherein the shutter system (3, 4, 5, 6, 7) comprises a first shutter plate (3), a first linear motor (6), a second shutter plate (4), a second linear motor (7) and a linear guide (5), with the first linear motor (6) and the second linear motor (7) being movable along the linear guide (5), and with the first linear motor (6) being connected to the first shutter plate (3) and with the second linear motor (7) being connected to the second shutter plate (4).

10. Processing system (1) according to claim 9, wherein the shutter system further comprises a third shutter plate, a third linear motor, a fourth shutter plate, a fourth linear motor and a second linear guide, with the third linear motor and the fourth linear motor being movable along the second linear guide, with the third linear motor being connected to the third shutter plate and with the fourth linear motor being connected to the fourth shutter place, wherein the second linear guide is arranged in a substantially orthogonal manner with respect to the linear guide, wherein the first shutter plate and the second shutter plate are coplanar, and wherein the third shutter plate and the fourth shutter plate are coplanar and lie in a different plane compared to the first shutter plate and the second shutter plate.

11. Processing system (1) according to any one of claims 1 to 8, wherein the shutter system comprises a circular shutter plate with a hole, wherein a hole centre of the hole is positioned away from a shutter plate centre of the circular shutter plate, with the circular shutter plate in particular being arranged above the mask plate and being parallel to the mask plate, and wherein the processing system comprises linear translation means enabling bidirectional translatory movement of the circular shutter plate along a main translation direction, which main translation direction in particular coincides with the main transport direction (17), and wherein the processing system comprises rotation means for rotating the circular shutter plate with respect to a rotation axis passing through the shutter plate centre.

12. Bonding station comprising a processing system (1) according to any one of claims 1 to 11 and a bonding system.

13. Method for handling a workpiece carrier equipped with a workpiece in a processing system (1) according to any one of claims 1 to 11, wherein the processing system (1) is configured to interact with a bonding system for attaching a bonding partner to the workpiece, wherein a minimum spatial extent of the access opening (9) required by the bonding system for being able to insert the bonding partner into the main process section (2) and to attach the bonding partner to the workpiece comprises a minimum first spatial extent in the first access area direction (21) and a minimum second spatial extent in the second access area direction (22), wherein the method comprises the following steps:
• Moving the workpiece carrier into the main process section (2);
• Providing or receiving position information on a planned attachment position on the workpiece carrier, wherein the bonding system is scheduled to attach the bonding partner to the workpiece on the workpiece carrier at the planned attachment position; and
• Providing an adapted access opening based on the provided or received position information, wherein an adapted spatial extent of the adapted access opening is, in at least one of (i) the first access area direction (21) and (ii) the second access area direction (22), substantially equal to the minimum first spatial extent or the minimum second spatial extent, respectively.

14. Method for attaching a bonding partner to a workpiece in a bonding station according to claim 12, wherein the method comprises the following steps:
• Carrying out the method according to claim 13;
• Inserting the bonding partner through the adapted access opening into the main process section (2) and placing the bonding partner on the workpiece; and
• Attaching the bonding partner to the workpiece.

15. Computer program product comprising program code which, when executed on a computing unit of a processing system (1) according to any one of claims 1 to 11, causes the processing system (1) to carry out a method according to claim 13.
